# EUROPÄISCHE PATENTANMELDUNG

(11) **EP 2 408 074 A2**
(43) Veröffentlichungstag der Anmeldung: **18.01.2012**
(21) Anmeldenummer: 11172615.4
(22) Anmeldetag: 05.07.2011
(51) Int. Cl.: H02B 1/42

(54) **Gehäuse für Motorschutzschalter mit verschiebbaren Befestigungslöchern**

(30) Priorität: 15.07.2010 CH 11552010
(71) Anmelder: Britschgi, Josef, 6280 Hochdorf (CH)
(72) Erfinder: Britschgi, Josef, 6280 Hochdorf (CH)
(74) Vertreter: Felber, Josef

(57) **Zusammenfassung**

Das Alu-Pressgussgehäuse für Motorschutzschalter von Drehstrommotoren mit verschiebbaren Befestigungslöchern weist im Gehäuseboden (1) und in der Schiebeplatte (2) je zwei Schraubenschlitze (5) auf. Auf diese werden je zwei rechteckige Unterlagscheiben (3) mit Schraubenloch (4) gelegt und damit kann die Schraubenlochdistanz in der Breite des Gehäuses verschoben werden. Mit der in die Öffnung bzw. im Fenster (10) des Gehäusebodens (1) eingelegten Schiebeplatte (2) kann auch die Schraubenlochdistanz in der Richtung der Länge des Gehäuses verschoben werden. Das Gehäuse für Motorschutzschalter wurde speziell für den Einbau eines neuartigen "Sterndreieck Motorschutzschalters" ausgelegt. Das Gehäuse für Motorschutzschalter kann mit dem eingebauten Sterndreieck Motorschutzschalter ohne mechanische Arbeiten am Gehäuse auf die Klemmenkastenrahmen von Drehstrommotoren verschiedener Fabrikate, Baugrössen, Bauformen und Leistungen geschraubt werden kann.

## Beschreibung

Die Erfindung betrifft ein Gehäuse für Motorschutzschalter für Drehstrommotoren, mit verschiebbaren Befestigungslöchern, wodurch das Gehäuse ohne mechanische Nacharbeiten am Schalterboden auf die Klemmenkastenrahmen von Drehstrommotoren verschiedener Fabrikate, Baugrössen, Bauformen und Leistungen geschraubt werden kann.

Je nach Motorfabrikat, Baugrösse, Bauform und Leistung haben die Drehstrommotoren verschiedene Klemmenkasten-Lochdistanzen. Vor der Montage der bisherigen Sterndreieck Motorschutzschalter müssen am quadratischen Klemmenkastenrahmen die Distanzen der vier Befestigungslöcher gemessen und auf dem Boden des Schaltergehäuses angerissen und gebohrt werden. Dies muss an einem leeren Schaltergehäuse geschehen. Die Schalterkomponenten müssen ausgebaut, der Schalterboden muss bearbeitet und die Schalterkomponenten müssen wieder eingebaut werden. Für diese Arbeiten wird etwa eine Stunde benötigt.

Die Aufgabe der vorliegenden Erfindung ist es deshalb, diese Nachteile zu überwinden und ein Gehäuse für Motorschutzschalter zu schaffen, welches ohne mechanische Nacharbeiten am Schalterboden auf die Klemmenkastenrahmen von Drehstrommotoren verschiedener Fabrikate, Baugrössen, Bauformen und Leistungen geschraubt werden kann.

Diese Aufgabe wird gelöst von einem Gehäuse für Sterndreieck Motorschutzschalter von Drehstrommotoren, bestehend aus einem schachtelartigen Gehäuse mit Deckel, das sich dadurch auszeichnet, dass der Boden des Gehäuses vier in der Breite und in der Länge des Gehäuses verschiebbare Schraubenlöcher aufweist, sodass die Schraubenlöcher die Ecken jedes beliebig grossen Quadrates, Trapezes oder Rechteckes zwischen der Ausdehnung eines minimalen Quadrates und eines maximalen Quadrates einnehmen können, sodass das Gehäuse ohne mechanische Nacharbeiten auf die Klemmenkastenrahmen der Drehstrommotoren verschiedener Fabrikate, Baugrössen, Bauformen und Leistungen aufschraubbar ist.

Ein Ausführungsbeispiel der Erfindung wird nachfolgend anhand der Figuren beschrieben und die Funktion der einzelnen Teile wird erklärt.
Es zeigt:
- Figur 1:: Das Gehäuse mit Seitenwänden und Gehäuseboden in einer Draufsicht;
- Figur 2:: Die Schiebeplatte zum Gehäuseboden in einer Ansicht von oben;
- Figur 3:: Diese Schiebeplatte nach Figur 2 in einer Ansicht von der Seite;
- Figur 4:: Diese Schiebeplatte nach Figur 2 in einer Ansicht von unten;
- Figur 5:: Eine Unterlagscheibe;
- Figur 6:: Das Gehäuse mit eingelegter Schiebeplatte und eingelegten Unterlagscheiben, mit kleinstmöglichen Lochdistanzen;
- Figur 7:: Das Gehäuse mit gegenüber Figur 6 um 180° gedreht eingelegter Schiebeplatte und eingelegten Unterlagscheiben, mit grösstmöglichen Lochdistanzen;
- Figur 8:: Das Gehäuse mit Blick in sein Inneres, mit eingebauten Komponenten, ohne Deckel.

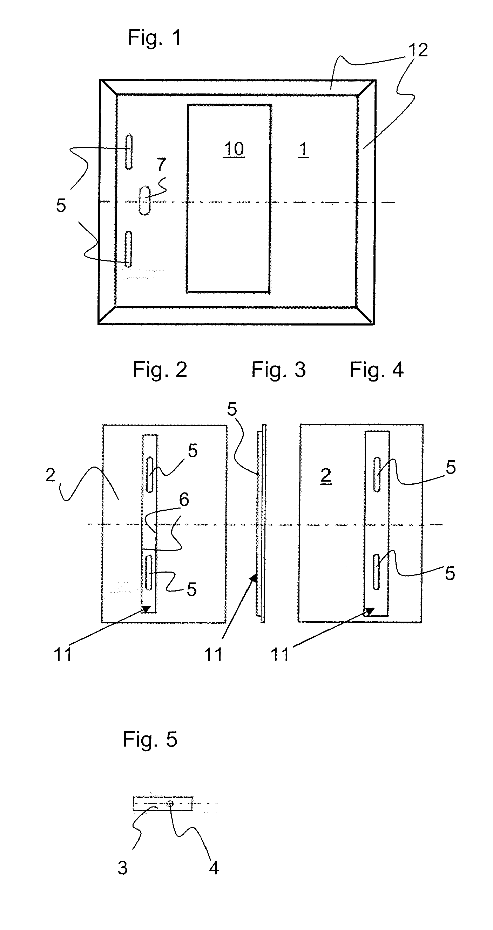

In den Figuren 1 bis 7 ist eine Ausführung dieses Gehäuses mit seinen einzelnen Teilen gezeigt, nämlich das Gehäuse ohne Deckel, mit Seitenwänden 12 und Gehäuseboden 1 von oben gesehen, mit im Gehäuseboben 1 ausgenommenem Fenster 10 und Kabelöffnung 7, sowie die Schiebeplatte 2 und die Unterlagscheiben 3. Das schachtelartige Gehäuse mit Deckel ist vorzugsweise aus Alu-Pressguss oder aus Kunststoff gefertigt. Im Gehäuseboden 1 nach Figur 1 sind am hier linken Rand zwei Schraubenschlitze 5 bzw. Langlöcher vorhanden. Auf diese werden rechteckige Unterlagscheiben 3 gemäss der Figur 5 aufgelegt, die je ein in der Länge der Unterlagscheibe etwas versetztes Schraubenloch 4 aufweisen. Die aufgelegten Unterlagscheiben 3 werden durch die anliegende Gehäusewand 12 gegen das Verdrehen gesichert und sind entsprechend der Länge der Schraubenschlitze 5 in Figur 1 in ihrer Längsrichtung hin und her verschiebbar. Bei diesen rechteckigen Unterlagscheiben 3 wird durch die längere Partie bis zum Schraubenloch 4 der jeweils nicht benützte, offen bleibende Bereich der Schraubenschlitze 5 abgedeckt.

Bei der Schiebeplatte 2 gemäss der Figur 2, hier in einer Ansicht von oben gezeigt, werden die rechteckigen Unterlagscheiben 3 mit dem Schraubenloch 4 in eine Führungsnut 6 eingelegt und sie sind in ihrer Längsrichtung gleich verschiebbar wie die Unterlagscheiben 3 auf dem Gehäuseboden 1. In Figur 4, in einer Ansicht der Schiebeplatte 2 von unten, ist die nach unten vorstehende Rippe 11 ersichtlich, welche den Boden der Führungsnute 6 in Figur 2 bildet. Mit der Figur 3 wird die Schiebeplatte 3 und die Rippe 11 von der Seite gesehen dargestellt. Diese Schiebeplatte 2 wird mit der vorstehenden Rippe 11 nach unten dichtend auf das Schiebeplattenfenster 10 aufgelegt und kann quer zur Verlaufrichtung der Führungsnut 6 entsprechend der Breite des Schiebeplattenfensters 10 abzüglich der Rippenbreite verschoben werden. Die Rippe 11 bildet beidseits einen Anschlag und begrenzt den Verschiebeweg.

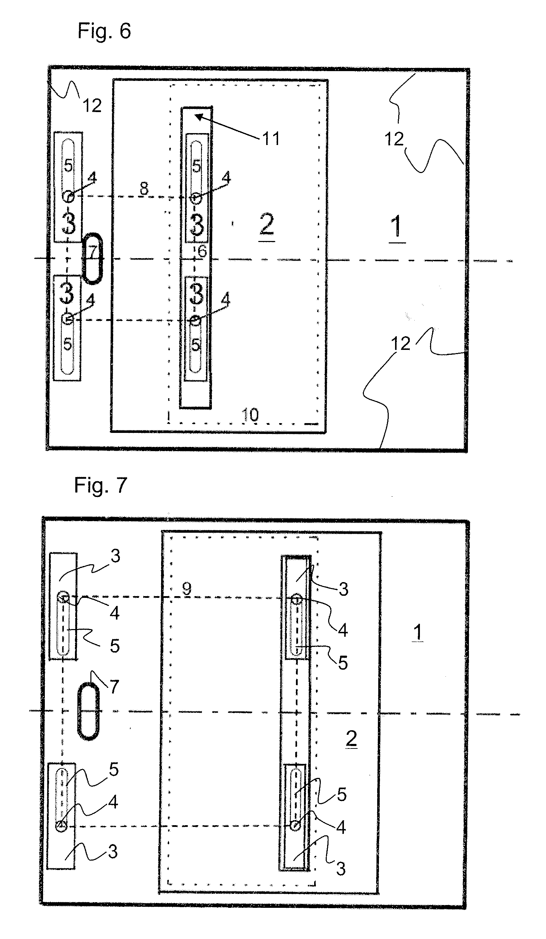

Die mit dieser Konstruktion des Gehäuses einstellbare minimale und die maximale Position der Schraubenlöcher 4 wird in Figur 6 und Figur 7 durch die strichliniert eingezeichneten Quadrate 8 und 9 aufgezeigt. Zwischen diesen beiden virtuellen Quadraten 8 und 9 können die Schraubenlöcher 4 auf jedes beliebige Zwischenmass eingestellt werden, das heisst sie können die Ecken jedes zwischenliegenden Quadrates, Trapezes oder Rechteckes bilden. In Figur 6 ist die Konstellation der Unterlagscheiben 3 und der Schiebeplatte 2 für die kleinste Lochdistanz dargestellt, gemäss dem strichliniert eingezeichneten Quadrat 8. Die Unterlagscheiben 3 auf den Schlitzen 5 im Gehäuseboden 1 sind so aufgelegt, dass ihre Löcher 4 mit kürzester Distanz einander zugewandt sind. Zusätzlich sind die beiden Unterlagscheiben 3 ganz gegeneinander hin verschoben, sodass die Schraubenlöcher 4 an den einander zugewandten Enden der Schlitze 5 zu liegen kommen. Die Schiebeplatte 2 ist mit ihrer Rippe 11 nach unten gerichtet so auf das Fenster 10 aufgelegt, dass die Führungsnut 6 nächstmöglich zu den Schlitzen 5 im Gehäuseboden 1 zu liegen kommt, und die Schiebeplatte 2 ist zusätzlich auf dem Fenster 10 ganz gegen links verschoben. Die zugehörigen Unterlagscheiben 3 sind so in die Führungsnut 6 eingelegt, dass ihre Schraubenlöcher 4 mit kürzester Distanz einander zugewandt sind. Zusätzlich sind die beiden Unterlagscheiben 3 ganz gegeneinander hin verschoben, sodass die Schraubenlöcher 4 an den einander zugewandten Enden der Schlitze 5 in der Rippe 11 zu liegen kommen.

Bei der Montage für die grösste statt für die kleinste Lochdistanz wie sie in Figur 7 mit dem strichliniert eingezeichneten Quadrat 9 dargestellt ist, müssen die rechteckigen Unterlagscheiben 3 gegenüber der Position in Figur 6 um 180° in ihrer Längsrichtung gedreht eingelegt werden und ganz voneinander weggeschoben werden, sodass ihre Schraubenlöcher 4 über den äusseren Enden der Schlitze 5 zu liegen kommen. Die Schiebeplatte 2 wird im Vergleich zur Figur 6 ebenfalls um 180° gedreht auf das Fenster 10 aufgelegt und dann auf dem Fenster 10 ganz nach rechts verschoben. Die Unterlagsscheiben 3 werden auf den Schlitzen 5 in der Rippe 11 der Schiebeplatte 2 so weit wie möglich voneinander weggeschoben. Damit ergibt sich die maximale Lochdistanz, entsprechend dem eingezeichneten Quadrat 9. Durch dieses simple bedarfsweise Einlegen der Schiebeplatte 2 und der Unterlagscheiben 3 ergibt sich eine höchst vielseitige Einstellbarkeit bei allereinfachster Konstruktion. In den Figuren 6 und 7 ist auch die Kabelöffnung 7 für sechs Wicklungskabel gezeigt, für die zwei Temperaturwächterlitzen und das Erdungskabel.

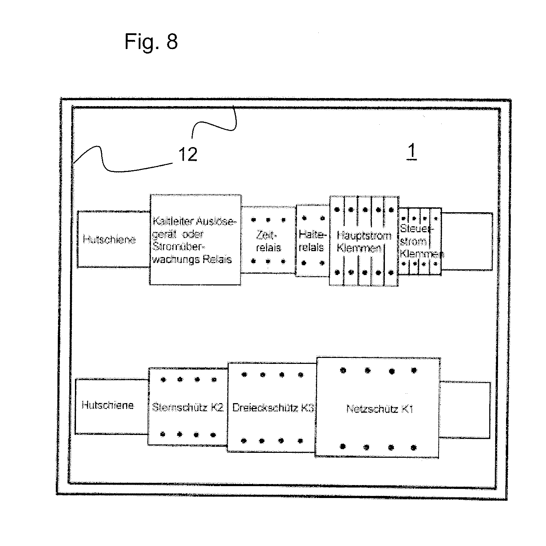

In Figur 8 ist als Beispiel gezeigt, wie ein Sterndreieck Motorschutzschalter auf diesem Gehäuseboden 1 montiert ist. Es handelt sich hier um einen besonderen, neuentwickelten Sterndreieck Motorschutzschalter mit automatischer Umschaltung von Stern- auf Dreieckschaltung. Und das hier beschriebene Motorschutzschalter-Gehäuse wurde speziell für einen solchen Sterndreieck Motorschutzschalter mit automatischer Umschaltung von Stern auf Dreieck dieser besonderen Bauart entwickelt. Auf zwei Hutschienen in dem hier beschriebenen Gehäuse sind die Komponenten für einen solchen Sterndreieck Motorschutzschalter dargestellt. Auf der Hutschiene unten im Bild befinden sich das Sternschütz K2, das Dreieckschütz K3 und das Netzschütz K1. Auf der Hutschiene oben im Bild befinden sich das Kaltleiter-Auslösegerät oder das Stromüberwachungs-Relais, das Zeitrelais, das Halterelais, die Hauptstrom-Klemmen und die Steuerstrom-Klemmen. Dieser Motorschutzschalter ist Gegenstand einer eigenen Patentanmeldung. Der neue Schalter bringt grosse Vorteile bezüglich Preis, längerer Lebensdauer der Kontakte und durch die Anwendung des Motorschutzes durch Temperaturüberwachung wird auch eine Verlängerung der Lebensdauer der Motorwicklungen erzielt.

Mit der am Motor vorhandenen Dichtung für den quadratischen Klemmenkasten und mit den gelieferten Dichtungen für die Schiebeplatte 2 und für den Gehäusedeckel wird das Gehäuse beim Aufschrauben auf den Motor staubdicht abgeschlossen. Das Gehäuse mit Gehäusewand 12, die Schiebeplatte 2 und der abschliessende Gehäusedeckel sind vorzugsweise aus einem Alu-Pressguss gefertigt. Es sind aber auch Ausführungen aus Kunststoff oder gar aus Blech denkbar, zum Beispiel eine Blechkonstruktion, die im Tiefzieh-Verfahren erzeugt wird.

Die Pressguss-Gehäuse und die Kunststoff-Gehäuse bieten gegenüber Blechgehäusen aber ein Reihe von Vorteilen. Bei den Pressguss Gehäusen aus Alu oder Kunststoff können in den Gehäuseecken nach innen vorstehende dreieckige Rippen mitgegossen werden, mit vorgegossenen Schraubenlöchern für die Deckelschrauben. Bei Blechgehäusen müssen dafür vorgefertigte Winkel in vier separaten Operationen eingeschweisst oder gepunktet werden. Zum Festklemmen der von einem Gummi- oder Kunststoffmantel umgebenen Kabellitzen werden in einer Gehäusewand Kabelverschraubungen aus Messing oder Kunststoff verwendet. Die Klemmendeckelgehäuse der Drehstrommotoren sind mit eingeschraubten Kabelverschraubungen aus Metall oder aus Kunststoff versehen, welche der Fixierung der mit Gummi oder Kunststoff ummantelten Motoranschlusskabel dienen. Damit je nach Montagelage die Kabel von vorne, von hinten, von links oder von rechts zugeführt werden können, sind die Klemmenkastenrahmen quadratisch ausgeführt, damit die Kabel mit vier um 90° versetzten Positionen zugeführt werden können. Die Schalter werden anstelle der Klemmendeckelgehäuse auf den Klemmenkastenrahmen aufgeschraubt. Beim Gehäuse für 4 bis 11 kW Motoren muss in eine Gehäusewand ein Loch ⌀ 25,5mm für ein M25 Gewinde der Kabelverschraubung, und für das Stromzuleitungskabel muss ein Loch ⌀ 16,5mm für ein M16 Gewinde der Kabelverschraubung für das Kabel vom Hauptschaltergehäuse zum Tastaturgehäuse vorhanden sein. Das 16,5mm Loch wird nur benötigt, wenn das Tastaturgehäuse entfernt vom Motor an eine Wand oder in einem Tableau angeschraubt wird. Die im Pressverfahren hergestellten Gehäuse aus Alu oder Kunststoff weisen Wandstärken von etwa 3,5 bis 4mm auf. Bei den 16,5mm und 25,5mm Löchern muss auf eine Breite von 28mm und 40mm die Konizität der Aussen- und der Innenwand sehr klein sein, wegen der Auflage der Mutter für die Kabelverschraubung. Vom Inneren des Gehäuse her ist das 16,5mm und das 25,5mm Loch mit einer Wandstärke von 1 mm verschlossen. Bei Bedarf wird diese Verschlussrundelle herausgeschlagen und es kann die entsprechende Kabelverschraubung mit der Mutter montiert werden. Damit die Tiefziehkräfte für das Blechgehäuse nicht zu gross werden, muss ein möglichst dünnes Blech von 1 mm bis 1,5mm verwendet werden. Damit bei einer Zugbelastung durch das Kabel in der Kabelverschraubung die relativ grossflächige Gehäusewand nicht verbogen wird, muss auf der Innenseite durch ein aufgepunktetes Blech diese Wand verstärkt werden. Das Loch für die Zuleitungskabel-Verschraubung wird durch die beiden Bleche führend gestanzt. Das 16,5mm Loch für die Zuleitung zum Tastaturgehäuse wird ebenfalls gestanzt. So grosse Löcher können nur mit Sonderaufwand durch so dünne Wandstärken gebohrt werden. Wenn das Tastaturgehäuse an das Gehäuse des Schalters angeschraubt wird, muss das M16 Kabelloch durch eine Verschlussschraube M16 aus Kunststoff geschlossen werden. Zum Stanzen der M16 und M25 Kabellöcher muss ein spezieller Stanzblock gebaut werden. Der untere Teil des Blocks mit den Lochmatrizen muss links und rechts der Matrizen eine Aussparung für die beiden Seitenwände der Gehäuse haben, damit dieses soweit hereingeschoben werden kann, dass die beiden Löcher an der richtigen Position gestanzt werden können. Zum Bohren der vier Schraubenlöcher für die Hutschienen und dem Fräsen des Kabelschlitzes muss eine Stahlplatte unter dem Boden vorhanden sein, damit die Löcher und der Schlitz bei so kleiner Wandstärke gebohrt und gefräst werden können. Das Gleiche gilt beim Bohren der vier Befestigungslöcher an der Gehäusestirnseite zum Anschrauben des Tastaturgehäuses. Bei den Pressgussgehäusen werden diese Öffnungen eingegossen. Bei Blechgehäusen ist es aufwändig, zwischen Deckel und Gehäuse eine Nut für die Aufnahme einer Dichtung unterzubringen. Dazu muss ein vorgeformter Blechstreifen eingeschweisst oder eingepunktet werden, während beim Pressguss eine rechteckige Nute zur Aufnahme einer runden Gummischnur in den verbreiterten Deckelrand gegossen wird. Beim Blechgehäuse müssen für die Schiebeplatte zwei Bleche zugeschnitten werden. In die Schiebeplatte muss die Führungsnute gestanzt werden und in die nach unten vorstehende Rippe müssen die beiden Schraubenschlitze gestanzt werden und die beiden Bleche müssen durch Punktschweissen miteinander verbunden werden. Beim Pressgiessen der Schiebeplatte sind keine solchen Nacharbeiten erforderlich. Wegen den aufgezeigten Nachteilen und den Mehrkosten für das Blechgehäuse werden die Varianten Alu Pressguss oder Kunststoffgehäuse bevorzugt.

## Patentansprüche

1. Gehäuse für Sterndreieck Motorschutzschalter von Drehstrommotoren, bestehend aus einem schachtelartigen Gehäuse mit Deckel, ***dadurch gekennzeichnet,* dass** der Boden (1) des Gehäuses vier in der Breite und in der Länge des Gehäuses verschiebbare Schraubenlöcher (4) aufweist, sodass die Schraubenlöcher (4) die Ecken jedes beliebig grossen Quadrates, Trapezes oder Rechteckes zwischen der Ausdehnung eines minimalen Quadrates (8) und eines maximalen Quadrates (9) einnehmen können, sodass das Gehäuse ohne mechanische Nacharbeiten auf die Klemmen-Kastenrahmen der Drehstrommotoren verschiedener Fabrikate, Baugrössen, Bauformen und Leistungen aufschraubbar ist.

2. Gehäuse für Sterndreieck Motorschutzschalter von Drehstrommotoren nach Anspruch 1, ***dadurch gekennzeichnet,* dass** der Boden (1) des Gehäuses vier mindestens je in einer Richtung verschiebbare Schraubenlöcher (4) aufweist, von denen beide Lochpaare im Abstand untereinander, sowie das eine Lochpaar zusätzlich im Abstand zum anderen Lochpaar im Boden (1) des Gehäuses verschiebbar angeordnet ist, sodass die Schraubenlöcher (4) die Ecken jedes beliebig grossen Quadrates, Trapezes oder Rechtecks zwischen einem minimalen Quadrat (8) und einem maximalen Quadrat (9) einnehmen können, sodass das Gehäuse ohne mechanische Nacharbeiten auf die Klemmenkastenrahmen der Drehstrommotoren verschiedener Fabrikate, Baugrössen, Bauformen und Leistungen aufschraubbar ist.

3. Gehäuse für Sterndreieck Motorschutzschalter von Drehstrommotoren nach nach einem der vorangehenden Ansprüche, ***dadurch gekennzeichnet,* dass** der Boden (1) des Gehäuses vier in der Breite und in der Länge des Gehäuses verschiebbare Schraubenlöcher (4) aufweist, indem ein erstes Paar von Schraubenlöchern (4) durch rechteckige Unterlagscheiben (3) mit je einem Schraubenloch (4) gebildet sind, welche Unterlagscheiben (3) ihrer Länge nach über Schraubenschlitzen (5) in Form von Langlöchern im Gehäuseboden (1) längs einer Gehäusewand verschiebbar sind, und zwei weitere verschiebbare Schraubenlöcher (4) gebildet sind, indem ein zweites Paar von Schraubenlöchern (4) durch rechteckige Unterlagscheiben (3) mit je einem Schraubenloch (4) gebildet sind, welche Unterlagscheiben (3) ihrer Länge nach über Schraubenschlitzen (5) in Form von Langlöchern auf einer von innen in zwei wahlweise um jeweils 180° voneinander abweichenden Positionen dichtend auf den Gehäuseboden (1) aufgelegten Schiebeplatte (2) geführt sind, welche über einem Fenster (10) im Gehäuseboden (1) in Richtung senkrecht zu den Schraubenschlitzen (5) hin und her verschiebbar ist und dabei das Fenster (10) in allen Verschiebelagen dichtend abdeckt.

4. Gehäuse für Sterndreieck Motorschutzschalter von Drehstrommotoren nach einem der vorangehenden Ansprüche, ***dadurch gekennzeichnet,* dass** im Boden (1) zwischen den beiden Schraubenschlitzen (5) eine Öffnung (7) für die sechs Wicklungskabel, die zwei Temperaturwachterlitzen und das Erdleiterkabel des Sterndreieck Motorschutzschalters vorhanden ist.

5. Gehäuse für Sterndreieck Motorschutzschalter von Drehstrommotoren nach einem der Ansprüche 3 bis 4, ***dadurch gekennzeichnet,* dass** die über die Schraubenschlitze (5) gelegten rechteckigen Unterlagscheiben (3) im Gehäuseboden (1) in Richtung der Breite des Gehäuses verschiebbar sind, und dass die Schiebeplatte (2) im Gehäuseboden (1) ein rechteckiges Schiebeplattenfenster (10) abdeckt und in Richtung der Länge des Gehäuses verschiebbar ist, wobei auf der oberen Seite der Schiebeplatte (2) eine Führungsnut (6) in Form einer vertieften Rippe (11) vorhanden ist, in welcher zwei auf gleicher Linie liegende Schraubenschlitze (5) vorhanden sind.

6. Gehäuse für Sterndreieck Motorschutzschalter von Drehstrommotoren nach einem der vorangehenden Ansprüche, ***dadurch gekennzeichnet,* dass** die auf zwei Hutschienen montierten Komponenten für einen Sterndreieck Motorschutzschalter, bestehend aus Netzschütz K1, Dreieckschütz K3 und Sternschütz K2 auf einer einzigen Hutschiene angeordnet sind, und auf einer zweiten Hutschiene das Kaltleiter Auslösegerät oder das Stromüberwachungs-Relais, das Zeitrelais, das Halterelais, die Hauptstrom-Klemmen und die Steuerstrom-Klemmen angeordnet sind.

7. Gehäuse für Sterndreieck Motorschutzschalter von Drehstrommotoren nach einem der vorangehenden Ansprüche, ***dadurch gekennzeichnet,* dass** der Gehäuseboden (1) mit Seitenwänden (12), die Schiebeplatte (2) sowie der Gehäusedeckel aus einem Alu-Pressguss hergestellt sind.

8. Gehäuse für Sterndreieck Motorschutzschalter von Drehstrommotoren nach einem der Ansprüche 1 bis 6, ***dadurch gekennzeichnet,* dass** der Gehäuseboden (1) mit Seitenwänden (12), die Schiebeplatte (2) sowie der Gehäusedeckel aus einem Kunststoff hergestellt sind.

9. Gehäuse für Sterndreieck Motorschutzschalter von Drehstrommotoren nach einem der Ansprüche 1 bis 6, ***dadurch gekennzeichnet,* dass** der Gehäuseboden (1) mit Seitenwänden (12) und der Gehäusedeckel im Tiefziehverfahren aus Blech gefertigt ist, und dass die Schiebeplatte (2) aus zwei rechteckigen Blechen (5,6) besteht, einem grösseren Blech mit Führungsnute (6) und einem kleineren Blech mit zwei Schraubenschlitzen (5), und diese beiden Bleche durch Punktschweissungen vereinigt sind.

10. Gehäuse für Sterndreieck Motorschutzschalter von Drehstrommotoren nach einem der vorangehenden Ansprüche, ***dadurch gekennzeichnet,* dass** das Gehäuse oder sein Deckel mit einer Dichtung versehen ist, zum staubdichten Verschliessen des Gehäuses mit diesem Deckel.
